# EUROPEAN PATENT APPLICATION

(11) **EP 4 586 301 A1**
(43) Date of publication of application: **16.07.2025**
(21) Application number: 24208046.3
(22) Date of filing: 22.10.2024
(51) Int. Cl.: H01J 37/32, H01J 37/34, C23C 14/32

(54) **HYBRID CATHODES FOR ION PLASMA DEPOSITION SYSTEMS AND METHODS**

(30) Priority: 11.01.2024 US 202418409974
(71) Applicant: General Electric Technology GmbH, 5400 Baden (CH)
(72) Inventor: WEAVER, Scott A., Ballston Lake, 12019 (US); SUZUKI, Akane, Niskayuna, 12309 (US)
(74) Representative: Openshaw & Co.

(57) **Abstract**

A cathode (200) for use in an ion deposition process includes a main body (202) defining a working surface (204) of the cathode and at least one insert (218) coupled to the main body. The main body includes a first deposition material and the at least one insert includes a second deposition material that is incompatible with the first deposition material. The at least one insert is at least partially exposed at the working cathode surface. The first and second deposition materials are vaporizable in response to an electric arc generated at the working cathode surface for depositing a coating including the first and second deposition materials on a substrate.

## Description

The subject matter of this disclosure was made with Government support under Contract No. DE-AR0001420, awarded by the Department of Energy (DOE), and the Government has certain rights in the subject matter claimed herein.

### BACKGROUND

The field of the disclosure relates generally to ion plasma deposition, and, more particularly, to cathodes for use in ion plasma deposition systems and methods.

Ion plasma deposition (IPD) processes (also referred to as cathodic arc deposition or vacuum arc deposition) typically include placing a cathode into a vacuum environment, providing a substrate or workpiece within the vacuum environment, and inducing a current to the cathode to generate an electric (or cathodic) arc at a working surface of the cathode. The cathodic arc is formed at the working cathode surface after the cathode and an anode are placed in the vacuum environment, and a sufficient current is supplied to the cathode to create a sufficient potential between the cathode and the anode such that an electrical discharge is generated. The anode may be a conductive surface of the vacuum chamber or may be a separate structure within the vacuum chamber. The function of the anode is to sink electrons from the cathode to sustain the electrical discharge. The arc is formed for a short period of time, extinguishes, and reforms rapidly, giving the appearance that the arc is moving continuously over the working cathode surface.

The cathode is fabricated (e.g., cast, forged, or powder pressed) from deposition material (e.g., a metal or metal alloy) to be included in a coating deposited on the substrate. The cathodic arc erodes or vaporizes the deposition material at the working cathode surface. The erosion or vaporization of the deposition material from the working cathode surface forms a cloud of coating material containing highly energetic ions, charged particles, vapors and neutral droplets in the vacuum environment. This coating material is then available for deposition within the vacuum environment. The coating material may deposit on cooler surfaces in the vacuum environment via condensation, and/or on an anode surface because of electrical attraction as well as condensation. The workpiece provided in the vacuum environment also functions as such a surface on which the coating material is deposited. A voltage bias may be applied to the workpiece to affect material deposition by increasing the attraction of ions and charged particles to the surface.

Costs and material limitations pertaining to the manufacture and operation of the cathode may significantly limit the IPD process and the ability to deposit relatively complex coating compositions using IPD. For example, a cathode that is fabricated from a composition or alloy that does not provide suitable strength and/or ductility as a solid structure may prematurely break apart during manufacture or use, which may lead to unacceptable yield loss, poor coating quality, and/or non-transfer of material from the cathode during the IPD process. As a result, IPD processes that include a single cathode are limited with respect to the variety of compositions that can practicably be used to fabricate the cathode and subsequently deposited from the cathode without increasing the potential for cathode failure. Multiple cathodes may be required to deposit compositionally complex coatings, which increases manufacturing and/or equipment costs and complexity.

Accordingly, a need exists for IPD cathodes that enable a greater variety and more flexibility in the coating compositions that can be incorporated in and deposited using the cathode, that facilitate reducing the process costs associated with the IPD process, that allow the IPD process to be operated for longer periods of time without having to replace the cathode, and/or that facilitate depositing a more uniform and improved coating on a substrate.

This background section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, these statements are to be read in this light, and not as admissions of prior art.

### BRIEF DESCRIPTION

In one aspect, a cathode for use in an ion deposition process is provided. The cathode includes a main body defining a working surface of the cathode, and the main body includes a first deposition material. The cathode also includes at least one insert coupled to the main body. The at least one insert is at least partially exposed at the working cathode surface, and the at least one insert includes a second deposition material that is incompatible with the first deposition material. The first and second deposition materials are vaporizable in response to an electric arc generated at the working cathode surface for depositing a coating including the first and second deposition materials on a substrate.

In another aspect, an apparatus for depositing a coating on a substrate is provided. The apparatus includes a deposition chamber sized to receive the substrate therein and a cathode positioned in the deposition chamber. The cathode includes a main body defining a working surface of the cathode, and the main body includes a first deposition material. The cathode also includes at least one deposition insert coupled to the main body. The at least one deposition insert is at least partially exposed at the working cathode surface, and the at least one deposition insert includes a second deposition material that is incompatible with the first deposition material. The apparatus also includes a power supply coupled to the cathode. The power supply is operable to generate an electric arc at the working cathode surface for vaporizing the first and second deposition materials and depositing the coating including the first and second deposition materials on the substrate.

In another aspect, a method of depositing a coating on a substrate is provided. The method includes: providing a cathode including a main body defining a working surface of the cathode, wherein the main body includes a first deposition material; coupling at least one insert to the main body, wherein the at least one insert including a second deposition material that is incompatible with the first deposition material, such that the at least one insert is at least partially exposed at the working cathode surface; generating an electric arc at the working cathode surface to thereby vaporize the first and second deposition materials; and depositing the vaporized first and second deposition materials on a substrate.

### BRIEF DESCRIPTION OF DRAWINGS

These and other features, aspects, and advantages of the present disclosure will become better understood when the following detailed description is read with reference to the accompanying drawings in which like characters represent like parts throughout the drawings, wherein:
FIG. 1 is a schematic view of an exemplary ion plasma deposition (IPD) apparatus;
FIG. 2 is a perspective view of an exemplary cathode that may be used in the IPD apparatus shown in FIG. 1;
FIG. 3 is an exploded view of the cathode shown in FIG. 2;
FIG. 4 is an exemplary top view of a first alternative embodiment of the cathode of FIGS. 2 and 3;
FIG. 5 is an exemplary top view of a second alternative embodiment of the cathode of FIGS. 2 and 3;
FIG. 6 is an exemplary top view of a third alternative embodiment of the cathode of FIGS. 2 and 3;
FIG. 7 is an exemplary top view of a fourth alternative embodiment of the cathode of FIGS. 2 and 3;
FIG. 8 is an exemplary top view of a fifth alternative embodiment of the cathode of FIGS. 2 and 3; and
FIG. 9 is a flow diagram of an exemplary method of depositing a coating on a substrate.

Corresponding reference characters used throughout the drawings indicate corresponding parts. Unless otherwise indicated, the drawings provided herein are meant to illustrate features of embodiments of the disclosure. These features are believed to be applicable in a wide variety of systems comprising one or more embodiments of the disclosure. As such, the drawings are not meant to include all conventional features known by those of ordinary skill in the art to be required for the practice of the embodiments disclosed herein.

### DETAILED DESCRIPTION

The exemplary embodiments described herein relate to systems and methods for depositing a coating on a substrate using an ion plasma deposition (IPD) process (also referred to as cathodic arc deposition or vacuum arc deposition). The IPD process may be used to deposit metallic and/or non-metallic coatings. In some embodiments, the IPD process may be used to deposit coatings on a component used in a turbine engine (e.g., a hot gas path component such as a turbine blade or a nozzle vane). The turbine engine components may be intended for use in high-temperature and highly oxidative environments, and the components may be fabricated from nickel, cobalt, and/or iron-based alloys, or refractory metal-based alloys, that are resistant to such environments. The IPD process may be used to deposit additional temperature-resistant and/or wear-resistant coatings on the turbine engine component to protect the underlying alloys against oxidation and heat-induced corrosion. Additionally and/or alternatively, the deposited coatings may also serve as bond coating used to retain a corrosion-resistant coating. Suitable deposited corrosion-resistant coatings used in turbine engine applications may include, but are not limited to only including, nickel aluminide-based coatings that may be modified by additions of platinum to form a platinum nickel aluminide-based coating, and/or coatings that include an alloy of chromium, aluminum, and at least one of iron, nickel, and cobalt. The IPD process may be a suitable alternative for depositing such corrosion-resistant coatings over known physical vapor deposition techniques, such as electron beam physical vapor deposition (EBPVD), and/or chemical vapor deposition techniques, both of which are limited in their ability to produce and maintain compositional control over the compositional complexity that these corrosion-resistant coatings demand.

The IPD process is a physical vapor deposition process that sequesters an electric (or cathodic) arc on a working surface of a cathode. The cathode is positioned in a vacuum chamber which may in turn act as an anode as current is supplied to the cathode to generate the electric arc. As the electric arc traverses the working cathode surface, highly energetic ions are ejected from the working surface and are accelerated toward the substrate to be coated. A solid vaporized from the working cathode surface is converted to vapor and then re-condensed on the substrate to deposit as a coating. The cathode is fabricated (e.g., cast, forged, or powder pressed) from deposition material (e.g., a metal or metal alloy) which has a composition selected to achieve a desired composition of the deposited coating. However, significant technical challenges related to the manufacture and/or use of the cathode may arise. For example, depending on the composition of the coating, it may be difficult or impossible to fabricate a cathode from the deposition material required to produce the coating. The composition of the requisite deposition material may be such that the cathode fabricated from the deposition material does not have sufficient strength and/or ductility to withstand mechanical loads and stresses experienced during manufacture and/or use of the cathode without prematurely breaking apart, which may lead to unacceptable yield loss, poor coating quality, and/or non-transfer of material from the cathode during the IPD process.

The exemplary systems and methods described herein include using "hybrid" cathodes that include a main body fabricated from a first deposition material and at least one insert coupled to the main body that is fabricated from a second deposition material, wherein the second deposition material is different from the first deposition material. The first and second deposition materials are each suitably vaporizable in response to an electric arc generated at a working surface of the cathode for depositing a coating including the first and second deposition materials on a substrate. The first and second deposition materials may be incompatible with each other, such that a cathode otherwise fabricated (e.g., cast, forged, or powder pressed) from a mixture of the first and second deposition materials may have insufficient strength and/or ductility to withstand mechanical loads and stresses experienced during manufacture and/or use of the cathode without prematurely breaking apart. Coupling the at least one insert fabricated from the second deposition material to the main body fabricated from the first deposition material ensures that incompatible deposition materials included in the cathode remain separated until they are vaporized and deposited on the substrate. Accordingly, the exemplary hybrid cathodes enable the "tuning" of the deposition material composition included in the cathode for depositing on the substrate, by enabling different, incompatible materials to be coupled mechanically to the main body of the cathode. In some embodiments, the main body of the cathode may be machined (e.g., drilled) to form openings or bores in the working cathode surface. Inserts (e.g., rod, poles or studs) fabricated from different materials are inserted into the openings and retained therein. The inserts may be forcibly inserted into the corresponding openings and retained therein via a friction fit. Additionally and/or alternatively, the inserts may be retained in the corresponding openings using threads. Such inserts may also be readily removed from the main body and replaced with other inserts fabricated from other materials for deposition. As the cathode can be used to tune chemistries quickly and accurately without waiting for additional cathodes to manufactured, such a cathode may be particularly useful for research and other applications wherein the use of wide variety materials in a single cathode may be advantageous. In some embodiments, the hybrid cathode may also be configured in such a way that the cathodic arc can be controlled as it circumnavigates the working cathode surface. For example, the working cathode surface may be "dished" or "sunk" such that the cathodic arc is driven toward a center region of the working cathode surface to ensure uniform erosion or vaporization or otherwise prevent the cathodic arc from concentrating in undesired locations at the working cathode surface. Additionally and/or alternatively, movement of the cathodic arc may be controlled using insulating inserts that are coupled to the main body and strategically positioned to control arc movement. The insulating inserts may be fabricated from an insulating material that the cathodic arc will avoid and thus shift towards other areas on the working cathode surface. The insulating material may be alumina, boron nitride, or another suitable insulating material that will not support a cathodic arc. In this way, the hybrid cathodes may be tuned to "force" the cathodic arc to uniformly and efficiently vaporize the desired materials included in both the main body and the deposition material inserts.

The exemplary hybrid cathodes overcome at least some of the current limitations of IPD processes, including facilitating reducing costs and overcoming the inability to deposit compositionally-complex coatings. Additionally, the exemplary hybrid cathodes enable additional deposition materials to be available to the coating process and enable the IPD process to be operated for longer periods of time without having to replace the cathodes, and thus significantly impact costs associated with the IPD process. Further, by configuring the cathode to control movement of the cathodic arc at the working surface, a more uniform and improved coating material may be deposited.

When introducing elements of various embodiments disclosed herein, the articles "a," "an," "the," and "said" are intended to mean that there are one or more of the elements and include plural references unless the context clearly dictates otherwise. "Optional" or "optionally" means that the subsequently described event or circumstance may or may not occur, and that the description includes instances where the event occurs and instances where it does not. Furthermore, references to "one embodiment" are not intended to be interpreted as excluding the existence of additional embodiments that also incorporate the recited features. Moreover, unless explicitly stated to the contrary, the terms "comprising," "including," and "having" are intended to be inclusive and mean that there may be additional elements other than the listed elements.

Unless otherwise indicated, approximating language, such as "generally," "substantially," "approximately," and "about," as used herein indicates that the term so modified may apply to only an approximate degree, as would be recognized by one of ordinary skill in the art, rather than to an absolute or perfect degree. Accordingly, a value modified by a term or terms such as "about," "approximately," and "substantially" is not to be limited to the precise value specified. In at least some instances, the approximating language may correspond to the precision of an instrument for measuring the value.

Unless otherwise indicated, the terms "first," "second," etc. are used herein merely as labels, and are not intended to impose ordinal, positional, or hierarchical requirements on the items to which these terms refer. Moreover, reference to, for example, a "second" item does not require or preclude the existence of, for example, a "first" or lower-numbered item or a "third" or higher-numbered item.

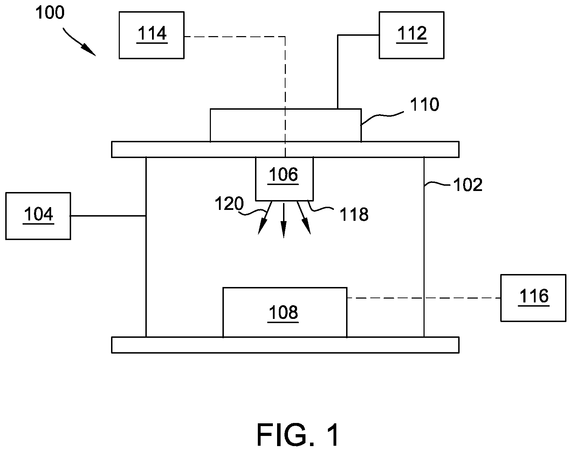

Referring now to the drawings, FIG. 1 is a schematic view of an exemplary ion plasma deposition (IPD) apparatus 100, which may include additional or other components other than those shown and described with reference to FIG. 1 to enable the IPD apparatus 100 to function as described herein. The IPD apparatus 100 may also be referred to as a cathodic arc deposition apparatus or a vacuum arc deposition apparatus. In the exemplary embodiment, the IPD apparatus 100 includes a vacuum chamber 102 in fluid communication with a vacuum system 104. The vacuum system 104 is operable to generate a vacuum in the vacuum chamber 102, that is, to generate a partial pressure in the vacuum chamber that is below that of atmospheric pressure.

The IPD apparatus 100 also includes a cathode 106 positioned within the vacuum chamber 102. The cathode 106 is fabricated from any suitable material (e.g., a metal or metal alloy) for deposition on a workpiece 108 (also referred to herein as a substrate 108) using the IPD apparatus 100. The workpiece 108 is also positioned in the vacuum chamber 102 a distance from the cathode 106. In the exemplary embodiment, the cathode 106 is above the workpiece 108, but the relative positioning between the cathode 106 and the workpiece 108 in the vacuum chamber 102 may vary in other embodiments. The vacuum chamber 102 may also contain, in addition to the cathode 106 and the workpiece 108, an anode (not shown). The anode may be a conductive surface of the vacuum chamber 102, or may be a separate anode within the vacuum chamber. The anode may be provided to sink electrons from the cathode 106 to sustain an electrical discharge generated at the cathode during the IPD process. In some embodiments, the workpiece 108 may function as the anode within the vacuum chamber 102.

The workpiece 108 may be any article or component on which a coating (e.g., a metal or metal alloy coating) is deposited using the IPD apparatus 100. The workpiece 108 may suitably be fabricated from a metal or metal alloy material. The coating deposited from the cathode 106 on the workpiece 108 using the IPD apparatus 100 may provide a layer of protection or some other function on a surface of the workpiece. In some embodiments, the workpiece 108 is a component used in a high temperature and/or oxidative environment of a rotary machine and the coating deposited from the cathode 106 provides a corrosion-resistant layer across a surface of the component. For example, the workpiece 108 may be a component used in a combustion chamber or a hot gas path of a turbine engine, such as a turbine blade, vane, nozzle, liner, transition piece, and/or the like. In such embodiments, the workpiece 108 may include at least one of a nickel alloy, an iron alloy, a cobalt alloy, and a nickel-iron alloy, including, but not limited to only including, high strength, high temperature alloys also known in the art as "superalloys." Such superalloys may contain about 50% or more by weight of nickel, cobalt, iron, or nickel-iron, in addition to alloying elements added to facilitate improving the mechanical and physical properties of these alloys. For example, in some embodiments, the workpiece 108 may be fabricated from nickel-based superalloys such as CMSX-49, René N4^{™}, René N5^{™}, René 108^{™}, GTD-111^{®}, GTD-2229, GTD-444^{®} and IN-738. René N4^{™}, René N5^{™}, René 108^{™}, and/or GTD-111^{®}. GTD-222^{®} and/or GTD-444^{®} comprise gamma prime-strengthened nickel-base superalloys. In some embodiments, the workpiece 108 may be fabricated from cobalt-base superalloys such as FSX-414. In other embodiments, the workpiece 108 may include refractory metal-based alloys, such as, for example, alloys containing one or more of niobium, molybdenum, tantalum, tungsten, rhenium, titanium, vanadium, chromium, zirconium, hafnium, ruthenium, rhodium, osmium, and iridium. While certain alloys have been described herein for the workpiece 108, it should be appreciated that these are exemplary only and are not intended to be limiting. The material used may vary depending on the intended application of the workpiece 108.

The IPD apparatus 100 may be used in applications in which a coating is deposited on a newly fabricated workpiece 108 and/or in applications in which a coating is deposited on a workpiece that has been previously used in operation. For example, the IPD apparatus 100 is suitable for use in a repair process for workpieces 108 that have been previously installed and used in a high temperature and/or oxidative environment, such as a turbine component previously used in a hot gas path or combustion chamber of a turbine engine. Accordingly, in certain embodiments, the workpiece 108 may already include at least one coating prior to the workpiece 108 being positioned in the vacuum chamber 102. Depending on the composition and condition of the existing coating on the workpiece 108, the existing coating may be removed prior to performing an IPD process using the apparatus 100, or the IPD process may be performed on the workpiece without removing the prior coating.

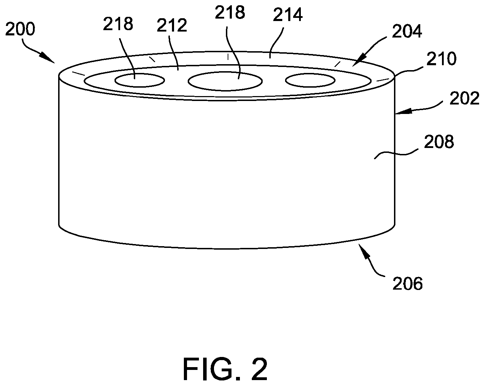

Exemplary cathodes used as the cathode 106 will be described in further detail below (with reference to FIGS. 2-8). In general, in the exemplary embodiment, the cathode 106 includes material(s) suitable for depositing a coating on a workpiece 108 that has a composition to enable the coating to function as desired. The material(s) included in the cathode 106 may be referred to herein as cathode material(s) or deposition material(s). The particular composition of the cathode 106 may depend on several factors, including, but not limited to only including, the type of workpiece 108 and the type of environmental exposure expected to be endured by the workpiece 108 when used. In various examples, the cathode 106 may include, but is not limited to including, one or more elements selected from nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, and/or combinations thereof. The cathode 106 may include additional and/or alternative elements such as carbon and boron depending on the desired application of the coating.

The cathode 106 may be formed in any suitable shape for use in the IPD apparatus 100, such as, but not limited to, a cylinder. The cathode 106 is formed with an end face 118 from which material of the cathode is eroded or vaporized for depositing the coating on the workpiece 108. The end face 118 may also be referred to as a working surface 118 of the cathode 106. Metallurgical and manufacturing processes such as casting and powder metallurgy processing, for example, are suitably used to fabricate the main body (e.g., the primary cylindrical portion) of the cathode 106 from a mixture of the cathode material for deposition. However, such techniques are often limited in that the materials that are incorporated in the cathode 106 from the mixture must be compatible with each other. If the materials are not compatible, the cathode 106 may not be of sufficient strength and/or ductility, and may prematurely break apart (i.e., fail) either during or prior to the IPD process.

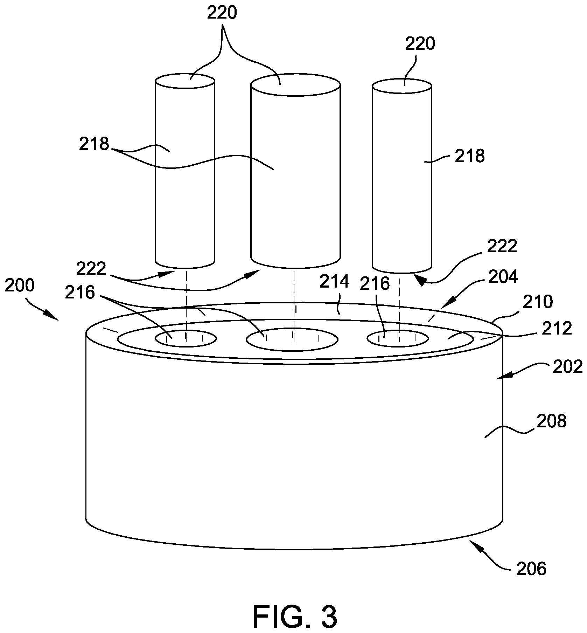

Accordingly, as described in further detail below, exemplary cathodes 106 used in the exemplary IPD apparatus 100 include one or more inserts (e.g., the inserts 218 best seen in FIG. 3) fabricated from additional deposition material(s) that is incompatible with the deposition material included in the main body of the cathode 106. Such inserts 218 are coupled to the main body of the cathode 106 to enable the incompatible deposition materials included in the inserts 218 and the main body of the cathode 106 to be deposited in the coating concurrently without the cathode 106 prematurely breaking apart (i.e., failing). The exemplary cathodes 106 described herein thereby facilitate depositing a wide variety of coating compositions and increasing an amount of flexibility in the IPD process. Additionally, the inserts 218 may be selectively installed and removed from the main body of the cathode 106, enabling this portion of the cathode 106 to be salvaged and re-used with inserts fabricated from other deposition material(s). As such, the exemplary cathodes 106 facilitate reducing costs and overcoming the limitations in known IPD apparatus, as well as facilitate the controlled incorporation of incompatible materials into a single cathode having suitable strength and/or ductility for manufacture and use in the IPD process.

In the exemplary embodiment, the cathode 106 may be supported in the vacuum chamber 102 by an evaporator plate 110. The evaporator plate 110 may be cooled via a cooling fluid supply 112 that channels cooling fluid to and from the evaporator plate 110. The cooling fluid supplied to the evaporator plate 110 may circulate through internal passages (not shown) formed in the evaporator plate 110 to facilitate cooling during operation of the IPD apparatus 100.

The IPD apparatus 100 also includes one or more power supplies 114, 116 (or current sources) that operate to generate a cathodic (or electric) arc at the working cathode surface 118. The power supplies 114, 116 may any suitable source for generating the cathodic arc at the working cathode surface 118, such as direct current (DC) power supply (e.g., an arc welder). In the exemplary embodiment, the cathode 106 that includes the material to be deposited on the workpiece 108 is coupled to a first DC power supply 114. An amount of current supplied to the cathode 106 using the DC power supply 114 may be determined, at least in part, by the cathode material and a desired rate of erosion or vaporization of the coating material from the working cathode surface 118. The melting point of the cathode materials may be a factor in determining a suitable current to supply to the cathode 106. Greater or smaller currents may be applied to the cathode 106 to selectively increase or decrease erosion or vaporization rate.

A negative voltage bias may be induced to the workpiece 108 using a second DC power supply 116 coupled to workpiece. In other embodiments, the second DC power supply 116 may be coupled to the anode (not shown) contained in the vacuum chamber 102, or may be omitted from the IPD apparatus 100. In some embodiments, the cathode 106 and the workpiece 108 (or other anode) may be coupled to opposite terminals of a single power supply, such as the DC power supply 114 or 116. The negative voltage bias may be applied to the workpiece 108 to affect material deposition by increasing the attraction of ions and charged particles to the workpiece 108 from the working cathode surface 118. Applying the negative voltage bias may additionally and/or alternatively heat the workpiece 108 and may result in an increase in a temperature of the workpiece 108 during the IPD process. Such heating of the workpiece 108 may cause interdiffusion and reaction among the elements of the deposited material and the material of the workpiece to form, in situ, a coating composition on the workpiece. The particular value chosen for the voltage bias may depend on various factors including, for example, the amount and type of interaction desired to occur between the deposited material and the material of the workpiece 108.

In operation of the IPD apparatus 100, the cathode 106 and the workpiece 108 are positioned in the vacuum chamber 102 as shown in FIG. 1. The vacuum system 104 is operated to produce a vacuum in the vacuum chamber 102. The cathode 106 is supplied with a current, from the first DC power supply 114 for example, to create a sufficient potential between the cathode 106 and the workpiece 108 (and/or an anode positioned in the vacuum chamber 102). The workpiece may also be provided with a negative voltage bias, using the second DC power supply 116 for example. An electric (or cathodic) arc is generated at the working cathode surface 118, resulting in erosion or vaporization of cathode material from the working cathode surface. The cathodic current is concentrated at minute, extremely energetic cathode arc spots, and creates a highly ionized metal plasma from the erosion or vaporization of the cathode material at the working cathode surface 118. The cathodic arc is formed for a short period of time, extinguishes and reforms rapidly, giving the appearance that the arc is moving continuously over the working cathode surface 118. The erosion or vaporization of the cathode material at the working surface 118 forms a cloud of droplets and ions of coating material (indicated by the arrow 120 in FIG. 1) within the vacuum chamber 102. The cloud of coating material 120 contains ions, charged particles, vapors and neutral droplets in the vacuum environment. The coating material 120 is deposited from the cloud on a surface of the workpiece 108 via condensation and/or electrical attraction. Electrical attraction may be controlled (e.g., increased) using the negative voltage bias applied to the workpiece 108 to facilitate attracting charged particles within the cloud of coating material 120 to the surface of the workpiece. A coating is thus deposited on the workpiece 108, a desired thickness of which may be determined by factors such as, for example, the intended application of the coated workpiece 108. The thickness of the coating deposited on the workpiece 108 may be controlled based on various IPD process parameters, for example, the duration of the IPD process, the pressure within the vacuum chamber, the current supplied to the cathode 106, the material included in the cathode, the ground potential or negative voltage bias applied to the workpiece 108, and/or other process parameters. The cathode 106 and/or the workpiece 108 may be rotated on a planetary (not shown) to provide uniform coatings on the workpiece.

FIGS. 2 and 3 illustrate an exemplary cathode 200 that may be used as the cathode 106 in the IPD apparatus 100 (shown in FIG. 1). FIG. 2 is a perspective of the exemplary cathode 200 and FIG. 3 is an exploded view of the cathode 200. In the exemplary embodiment, the exemplary cathode 200 includes a main body 202 that is cylindrical in shape and defines two end surfaces 204 and 206, and a circumferential edge 208 that extends between the end surfaces 204, 206. In other examples, the main body 202 of the cathode 200 may have any other suitable shape that enables the cathode to function as described herein. For example, the main body 202 of the cathode 200 may be another prismatic shape, having any suitable cross-sectional shape (e.g., oval, square, rectangular, or another polygonal shape), and including a pair of end surfaces 204, 206 and a side edge 208 extending therebetween. The cathode 106 may be suitably dimensioned depending, for example, on a desired thickness of the deposited coating.

A first end surface 204 defines the working cathode surface of the cathode 200, and functions as the working cathode surface 118 when the cathode 200 is used in the IPD apparatus 100 (shown in FIG. 1). Accordingly, during an IPD process using the cathode 200, the cathodic arc is generated at the working cathode surface 204 as described above and erodes or vaporizes material at the working cathode surface 204 for depositing on the workpiece 108. The second end surface 206 may be coupled to a component of the IPD apparatus 100 (e.g., the evaporator plate 110) for positioning the cathode 200 in the vacuum chamber 102. The second end surface 206 may be substantially flat or may have features (e.g., contours, slots, etc.) to enable the cathode 200 to be coupled to the IPD apparatus 100 within the vacuum chamber 102.

As shown in FIG. 2, the working cathode surface 204 may be "dished" or "sunk." In particular, the working cathode surface 204 of the exemplary cathode 200 includes a peripheral edge 210 adjacent the circumferential edge 208 of the main body 202 and a recessed surface 212 that is lowered relative to the peripheral edge 210. A downwardly-extending surface 214 may extend between the recessed surface 212 and the peripheral edge 210. Any suitable machining technique may be used to form the recessed surface 212 and the downwardly-extending surface 214 between the peripheral edge 208 and the recessed surface 212. Suitable machining techniques include, but are not limited to only including, hand grinding, milling, electrical discharge machining, and the like. The recessed surface 212 may form a main region of the working cathode surface 204, extending greater than about 50% of a radial distance (or diameter) of the working cathode surface. In other words, a distance spanned by the downwardly-extending surface 214 and the peripheral edge 210 between the recessed surface 212 and the circumferential edge 208 may be less than about 50% of the radial distance (or diameter) of the working cathode surface 204.

The surface 214 may be a chamfer between the peripheral edge 210 and the recessed surface 212, and may be referred to as a chamfered surface 214. The angle of the chamfered surface 214 may vary and may be selected depending on a desired "sink" of the recessed surface 212 from the peripheral edge 210. In various examples, the chamfered surface 214 may extend at an angle in a range of about 10° to about 80°. Relatively steeper angles of the chamfered surface 214 provide a greater sink of the recessed surface 212, and relatively gentler angles of the chamfered surface provide a smaller sink of the recessed surface.

The recessed surface 212 may be substantially flat in extent between the downwardly-extending surface 214, with the exception of bores or openings 216 (shown in FIG. 3) formed in the recessed surface 212 that receive corresponding inserts 218 fabricated from additional cathode or deposition material as will be described in further detail below. The peripheral edge 210 may be substantially flat in extent between the circumferential edge 208 and the downwardly-extending surface 214. In some embodiments, the downwardly-extending edge 214 may be omitted and the working cathode surface 204 may be generally concave to form a dished or sunk shape. In yet other embodiments, the working cathode surface 204 may be substantially flat in extent between the circumferential edge 208 of the main body 202, except for the openings 216 formed in the working cathode surface for receiving the corresponding inserts 218. The desired shape of the working cathode surface 204 may be provided by any suitable machining technique, such as, for example, hand grinding, milling, electrical discharge machining, and the like. Such machining techniques may also be used to form the openings 216.

Suitably, the dished or sunk shape of the working cathode surface 204 is provided to facilitate controlling movement of the cathodic arc during the IPD process. In particular, the shape of the working cathode surface 204 may drive the cathodic arc toward a center region of the working cathode surface 204 (e.g., the recessed surface 212) to facilitate controlling erosion or vaporization of the working cathode surface and/or facilitate preventing the cathodic arc from concentrating at spots along a periphery of the working cathode surface and proximate the circumferential edge 208 of the main body 202. This may facilitate increasing the longevity of the cathode 200 and/or improving material transfer from the cathode during the IPD process.

The main body 202 of the cathode 200 may be manufactured using suitable techniques, including, but not limited to only including, metallurgical and manufacturing processes such as casting and powder metallurgy processing. Suitable machining techniques, such as, for example, hand grinding, milling, electrical discharge machining, and the like, may also be used to machine the main body 202 to a desired shape and dimension and/or to machine the surfaces (e.g., the first and second end surfaces 204 and 206 and the circumferential edge 208) of the main body 202 to a desired shape and/or end finish.

The main body 202 of the cathode 200 is fabricated from a first deposition material vaporizable in response to an electric arc generated at the working cathode surface 204 and suitable for depositing on a substrate using the IPD process. The first deposition material may include, but is not limited to only including, one or more elements selected from nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, boron, and/or combinations thereof. In examples where the first deposition material includes a combination of elements (e.g., an alloy), the elements are suitably compatible with each other in their respective amounts. As used herein, the term "compatible" refers to elements and/or alloys that can be mixed in their respective amounts and used to fabricate (e.g., by casting, forging, or powder pressing) a solid structure of the cathode 200 (e.g., the main body 202 or an insert 218 of the cathode 200) having sufficient strength and/or ductility to withstand mechanical loads experienced during manufacture and/or use of the cathode without prematurely breaking apart (i.e., failing). "Incompatible" elements and alloys, as used herein, cannot practicably be mixed in their respective amounts and used to fabricate (e.g., by casting, forging, or powder pressing) a solid structure of the cathode 200 (e.g., the main body 202 or an insert 218 of the cathode 200) having sufficient strength and/or ductility to withstand mechanical loads experienced during manufacture and/or use of the cathode without prematurely breaking apart (i.e., failing). Thus, when the main body 202 is fabricated from the first deposition material including a mixture of compatible elements, the main body 202 has sufficient strength and/or ductility to prevent against failure of the main body 202, whereas when the main body 202 is fabricated from the first deposition material including a mixture of incompatible elements, the main body 202 has a greater propensity for failure.

In the exemplary embodiment, the cathode 200 also includes one or more inserts 218 that are coupled to the main body 202. The inserts 218 may also be referred to herein as deposition inserts. Each insert 218 is fabricated from a deposition material that, like the first deposition material, is vaporizable in response to an electric arc generated at the working cathode surface 204 and suitable for depositing on a substrate using the IPD process. Suitably, the deposition material used to fabricate each insert 218 is different from the first deposition material (e.g., is a different element or alloy). The deposition material used to fabricate each insert may include, but is not limited to only including, one or more elements selected from nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, boron, and/or combinations thereof. In examples where the deposition material used to fabricate one or more of the inserts 218 includes a combination of elements (e.g., an alloy), the elements are suitably compatible with each other.

In the exemplary embodiment, the deposition material used to fabricate one or more of the inserts 218 may be incompatible with the first deposition material included in the main body 202 of the cathode 200. For example, the deposition material used to fabricate each insert 218 may be an element or alloy that provides sufficient strength and/or ductility to prevent against failure of the insert 218, but when mixed with the first deposition material and the mixture is used to fabricate (e.g., by casting, forging, or powder pressing) the main body 202, the main body 202 has a greater propensity for failure. The deposition material used to fabricate the inserts 218 coupled mechanically to the main body 202 of the cathode 200 remains separated from (or not mixed with) the first deposition material of the main body 202 until they are vaporized and deposited during an IPD process. The inserts 218 thereby enable incompatible deposition materials (e.g., incompatible elements and/or incompatible alloys) to be concurrently deposited with the first deposition material by the IPD process using the cathode 200. Thereby, the provision of the inserts 218 coupled mechanically to the main body 202 enables a wide variety of deposited coating compositions and increasing an amount of flexibility in the IPD process.

The inserts 218 may each include the same deposition material or the inserts 218 may include different deposition materials. In some embodiments, one or some of the inserts 218 may be fabricated from a deposition material that is incompatible with a deposition material of another insert 218. The inserts 218 may be manufactured and machined to a desired size and shape using similar techniques as described above for the main body 202. For example, the inserts 218 may be manufactured from the desired deposition material using a casting or power metallurgy processing and subsequently machined to the desired size and shape using hand grinding, milling, electrical discharge machining, or the like. Additionally and/or alternatively, the inserts 218 may be sourced as a solid stock of deposition material from commercial suppliers and, optionally, further machined to a desired size and shape.

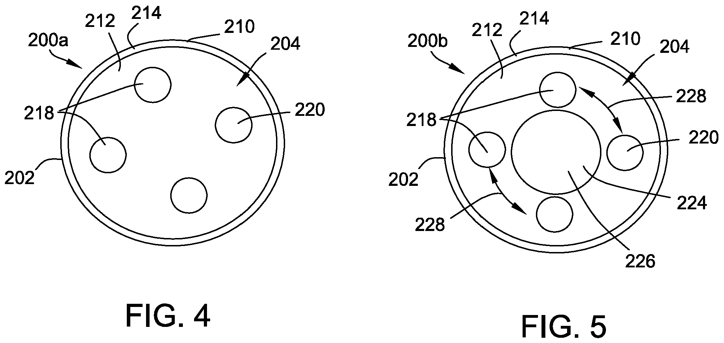

In the illustrated example of FIGS. 2 and 3, three inserts 218 are included in the cathode 200. In other embodiments, such as the embodiments described below with reference to FIGS. 4-8, the number of inserts 218 may vary. Any suitable number of inserts 218 may be included in the cathode 200, and the number of inserts 218 may vary depending on the deposition materials included in the cathode 200, the desired composition of the coating deposited using the IPD process, and the size of the inserts 218. In various examples, the number of inserts 218 included in the cathode 200 may be one, or more than one, such as two, three, four, five, six, seven, eight, nine, ten, or more than ten inserts 218. A relatively large number of inserts 218 (e.g., more than ten, more than twenty, or more than fifty) may be included where relatively smaller inserts 218 are used.

In the exemplary embodiment, each insert 218 is coupled to the main body 202 of the cathode 200 by positioning the insert 218 in a corresponding opening 216 formed in the working cathode surface 204. The openings 216 may also be referred to as bores 216. The inserts 218 are inserted into the corresponding bores or openings 216 and retained therein to couple the inserts to the main body 202. The inserts 218 may be forcibly inserted (or pressed) into the corresponding openings 216 and retained therein via a friction fit (or press fit). In these examples, each insert 218 and corresponding opening 216 are suitably dimensioned such that the insert is retained within the corresponding opening and will not prematurely decouple from the main body 202. Additionally and/or alternatively, the inserts 218 may be retained in the corresponding openings 216 using threads (i.e., via threaded engagement between the inserts and threads within the corresponding opening). In these examples, each insert 218 and corresponding opening 216 are suitably dimensioned and have corresponding threads such that the insert is threadedly retained within the corresponding opening and will not prematurely decouple from the main body 202. Any suitable attachment means may be used to couple the inserts 218 to the main body 202. In some examples, the inserts 218 are suitably coupled to the main body 202 without using additional mechanical elements, adhesive, etc. This may facilitate reducing the propensity for any external elements used to couple the insert 218 to the main body 202 to interfere with the cathodic arc during the IPD process.

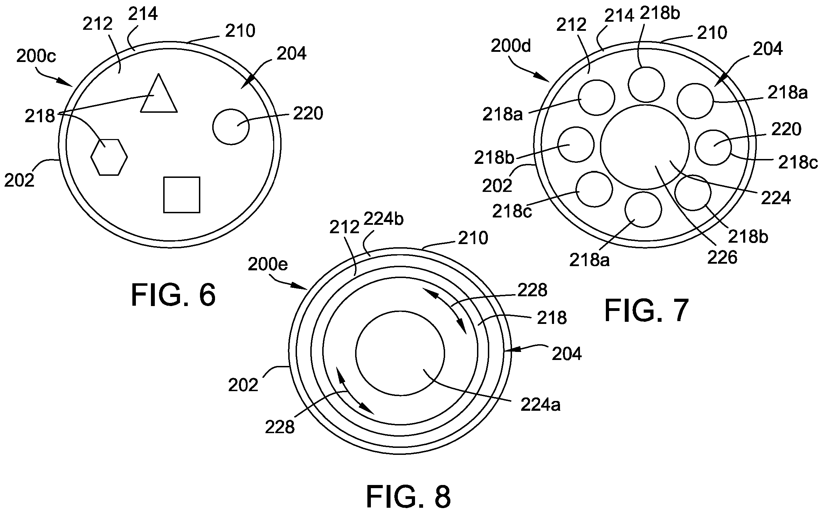

As shown in FIG. 3, each insert 218 may be in the shape of a cylindrical rod and has opposing end surfaces 220, 222. A length of each insert 218 (measured between the opposing end surfaces 220, 222) may be substantially equal to or smaller than the length of the main body 202 of the cathode 200. The size and shape of the inserts 218 may vary (see, e.g., FIG. 6). For example, the inserts 218 may have varying cross-sectional shapes, diameters, and/or lengths. The size and shape of each insert 218 may be determined depending on the desired amount of deposition material of the respective insert to be included in the deposited coating. Alternatively stated, inserts 218 that include a deposition material that is intended to be included in the deposited coating in a greater amount may be larger in size than inserts that include a deposition material that is intended to be included in the deposited coating in a smaller amount. The size and shape of the corresponding openings 216 may also vary depending on the size and shape of the corresponding insert 218 to enable the insert to be coupled to the main body 202 as described herein.

When each insert 218 is coupled to the main body 202 of the cathode 200, a first end surface 220 of the insert 218 is exposed at the working cathode surface 204. The first end surfaces 220 of the inserts 218 may also be referred to as exposed surfaces 220 or exposed portions 220 of the inserts 218. Each exposed surface 220 is eroded or vaporized by the cathodic arc generated at the working cathode surface 204 during the IPD process. The opposite second end surface 222 of each insert 218 may extend to the second end surface 206 of the main body 202 of the cathode 200, or may terminate prior to the second end surface of the main body where the insert is shorter in length than the main body.

Each insert 218 may be machined (e.g., by hand grinding, milling, electrical discharge machining, and the like) such that the exposed surface 220 matches a contour of the working cathode surface 204. In the exemplary embodiment, as shown in FIG. 2, each exposed surface 220 of the inserts 218 is located at the recessed surface 212 and may be machined to be substantially flat and flush with the recessed surface. Suitably, in embodiments where the working cathode surface 204 is dished or sunk, the exposed surfaces 220 of the inserts 218 are located radially inward from the downwardly-extending surface 214 such that the exposed portions are located in the path of the cathodic arc as controlled by the dished or sunk shape of the working cathode surface. In other embodiments, where the working cathode surface 204 is dished or sunk, the exposed surfaces 220 of the inserts 218 may be located at least partially at the downwardly-extending surface 214 and/or the peripheral edge 210. In these embodiments, the surfaces 220 may be machined to match the contour (e.g., a chamfer) of the radially-outer portions of the working cathode surface 204. In yet other embodiments, the working cathode surface 204 may be generally concave to form the dished or sunk shape, and the exposed surfaces 220 of the inserts 218 may be machined to match the concave shape of the working cathode surface. In yet other embodiments, the working cathode surface 204 may be substantially flat in extent between the circumferential edge 208 of the main body 202, and the and the exposed surfaces 220 of the inserts 218 may be machined to match the substantially flat shape of the working cathode surface. In embodiments where the working cathode surface 204 is generally concave or substantially flat, one or some of the inserts 218 may be located at radially-outer portions of the working cathode surface proximate the circumferential edge 208 of the main body 202.

Referring now to FIGS. 4-8, various exemplary alternative embodiments of the cathode 200 shown in FIGS. 2 and 3 having different exemplary configurations of the inserts 218 will now be described. Each of FIGS. 4-8 depicts a top view of an embodiment of the cathode 200 showing the working cathode surface 204 of the main body 202 and the exposed surfaces 220 of the inserts 218 at the working cathode surface. The inserts 218 are coupled to the main body 202 as described above. In the exemplary embodiments, the inserts 218 are received within corresponding openings 216 (shown in FIG. 3) formed in the working cathode surface 204 and retained therein via a friction (or press) fit or using threads. It is understood that the exemplary embodiments of the cathode 200 in FIGS. 2-8 are provided by way of example only, and the cathode 200 may include more, fewer, or other features than those shown and described. The inserts 218 may be coupled to the main body 202 using any suitable means of attachment. The features of the cathode 200 described in each embodiment herein may be combined in any combination or sub-combination.

In each alternative embodiment, the working cathode surface 204 may include the dished or sunk shape described above, an example of such a shape being shown in FIG. 2. In these embodiments, the exposed surfaces 220 of the inserts 218 may be located at, and substantially flush with, the recessed surface 212, and radially inward from the downwardly-extending surface 214. Additionally and/or alternatively, the exposed surfaces 220 of the inserts 218 may be located at least partially at the downwardly-extending surface 214 and/or the peripheral edge 210. In other embodiments, the working cathode surface 204 may be substantially flat or generally concave. The exposed surfaces 220 of the inserts 218 may be machined as described above to match a contour (e.g., flat, chamfer, concave) of the location of the working cathode surface 204 at which they are located.

FIG. 4 is a first exemplary alternative embodiment of the cathode 200, indicated generally at 200a. In this embodiment, the cathode 200a includes four inserts 218 coupled to the main body 202. More or fewer inserts 218 may be included in the cathode 200a. The main body 202 and the four inserts 218 each include a deposition material as described above. The deposition material of each of the four inserts 218 may be the same as or different from the deposition material of the other inserts 218. In some embodiments, at least one of the four inserts 218 includes a deposition material that is incompatible with the deposition material included in the main body 202 and/or the deposition material included in another one or more of the inserts 218. In the illustrated embodiment of FIG. 4, the four inserts 218 are coupled to the main body 202 such that the exposed surfaces 220 are arranged or spaced circumferentially at the working cathode surface 204. The circumferential arrangement of the exposed surfaces 220 of the inserts 218 may track the path that the cathodic arc travels at the working cathode surface 204 during the IPD process, which may be directed at least in part by the sunk or dished shaped of the working cathode surface. In other embodiments, the inserts 218 may be arranged in any suitable pattern to enable the cathode 200a to function as described herein.

FIG. 5 is a second exemplary alternative embodiment of the cathode 200, indicated generally at 200b. In this embodiment, the cathode 200b includes the four inserts 218 coupled to the main body 202 and having the exposed surface 220 arranged or spaced circumferentially at the working cathode surface 204, as described above for the cathode 200a of FIG. 4. The main body 202 and the four inserts 218 each include a deposition material as described above, and at least one of the inserts 218 may include a deposition material that is incompatible with the deposition material included in the main body 202 and/or the deposition material included in another one or more of the inserts 218. In addition, the cathode 200b of this embodiment includes an additional insert, indicated at 224, that is fabricated from an electrically insulating material that does not support a cathodic arc. In some examples, the additional insert 224 is fabricated from alumina or boron nitride. The additional insert 224 may also be referred to as an electrically insulating insert, or an insulating insert. The insulating insert 224 includes an exposed surface 226 at the working cathode surface 204. The insulating insert 224 may be similar in configuration to the other inserts 218, for example, may be similar in shape (e.g., a cylindrical rod) as the inserts 218. The insulating insert 224 is coupled to the main body 202 of the cathode 200b as described above for the inserts 218. For example, the insulating insert 224 may be received in a corresponding opening 216 (shown in FIG. 3) in the working cathode surface 204 and retained therein via a friction (or press) fit.

Suitably, the insulating insert 224 is provided to facilitate controlling movement of the cathodic arc during the IPD process at the working cathode surface 204. The insulating insert 224 may be included in addition to or in the alternative to the dished or sunk shape of the working cathode surface 204. The electrically insulating material (e.g., alumina or boron nitride) of the insulating insert 224 rejects the cathodic arc at the working surface 204 and drives the cathodic arc away from the insulating insert and toward other regions of the working cathode surface 204. In this way, the provision of the insulating insert 224 facilitates controlling movement of the cathodic arc at the working cathode surface, for example, to enable more uniform erosion or vaporization of the working cathode surface and facilitate preventing the cathodic arc from concentrating at undesired locations along the working cathode surface. This may facilitate increasing the longevity of the cathode 200b and improving material transfer from the cathode during the IPD process.

In the illustrated cathode 200b, a single insulating insert 224 is included and is coupled to the main body 202 such that the exposed surface 226 of the insulating insert is positioned in a center region of the working cathode surface 204. The exposed surfaces 220 of the inserts 218 and the deposition material of the main body 202 are located radially outward from the insulating insert 224. In this way, during the IPD process, the cathodic arc generated at the working cathode surface 204 avoids the insulating material (e.g., alumina or boron nitride) of the insulating insert 224, and circumnavigates the center region of the working cathode surface to erode or vaporize the deposition material included in the main body and the inserts that surround the exposed surface 226 of the insulating insert. Circumferential movement of the cathodic arc around the insulating insert 224 may further be controlled by the dished or sunk shape of the working cathode surface 204. That is, as the insulating insert 224 operates to control movement of the cathodic arc radially outward from the insulating insert, the dished or sunk shape of the working cathode surface 204 drives the cathodic arc radially inward. In this way, the insulating insert 224 and the dished or sunk shape of the working cathode surface 204 cooperate to control movement of the cathodic arc to concentrate along a circumferential path (indicated by arrows 228 in FIG. 5) located, for example, between the insulating insert and the downwardly-extending surface 214. Suitably, the exposed surfaces 220 of the inserts 218 are located at the region of the working cathode surface 204 where concentration of the cathodic arc is controlled.

The movement controlled by the cathodic arc using the insulating insert 224 and the working cathode surface 204 as illustrated in FIG. 5 is provided by way of example only. More insulating inserts 224 may be included, or one or more insulating inserts 224 may have exposed surfaces 226 at other locations at the working cathode surface 204, to control desired movement of the cathodic arc. The size and/or shape of the insulating insert 224 may also be adjusted (e.g., by changing a diameter of the exposed surface 226 at the working cathode surface 204) to control movement of the cathodic arc as described herein. Moreover, the insulating insert 224 may be suitably sized so as to optimize the operable surface area of the working cathode surface 204 that includes vaporizable deposition material while also enabling the insulating insert to function as described herein. The configurations of the insulating inserts 224 may be adjusted in addition to or in the alternative to adjusting the shape of the working cathode surface 204. In some embodiments, one or more insulating inserts 224 may be included and the working cathode surface 204 may be substantially flat. In these examples, multiple insulating inserts 224 may be provided that are annular in shape and facilitate concentrating the cathodic arc at annular regions located between radially-adjacent insulating insert 224 (see FIG. 8). In this way, movement of the cathodic arc at the working cathode surface 204 may be finely tuned and controlled using the insulating insert(s) 224 and/or the shape of the working cathode surface.

FIG. 6 is a third exemplary alternative embodiment of the cathode 200, indicated generally at 200c. The cathode 200c is similar to the cathode 200a (shown in FIG. 4) and includes the four inserts 218 coupled to the main body 202 and having the exposed surface 220 arranged or spaced circumferentially at the working cathode surface 204. As described above, the main body 202 and the four inserts 218 each include a deposition material, and at least one of the inserts 218 may include a deposition material that is incompatible with the deposition material included in the main body 202 and/or the deposition material included in another one or more of the inserts 218. The cathode 200c is illustrated without an insulating insert 224 (shown in FIG. 5), but may include an insulating insert in other examples. The inserts 218 in this example have different cross-sectional shapes, as shown in FIG. 6. The cross-sectional shapes are provided by way of example only, and the inserts 218 may have any suitable cross-sectional shape (e.g., circular, oval, triangular, square, rectangle, or another polygonal shape). The size and shape of the inserts 218 may vary depending on the deposition material included in the insert and the desired amount of that deposition material included in the deposited coating.

FIG. 7 is a fourth exemplary alternative embodiment of the cathode 200, indicated generally at 200d. In this embodiment, the cathode 200d includes eight inserts 218 each including an exposed surface 220 located radially outward from the insulating insert 224. The insulating insert 224 is positioned in a center region of the working cathode surface 204 as described above and the inserts 218 are arranged with the exposed surfaces 220 circumferentially arranged about the insulating insert. In this example, the main body 202 is fabricated from a first deposition material and the inserts 218 include first inserts 218a fabricated from a second deposition material, second inserts 218b fabricated from a third deposition material, and third inserts 218c fabricated from a fourth deposition material. The inserts 218a-c are arranged in alternating manner in the circumferential arrangement as shown in FIG. 7, but any arrangement of the inserts 218a-c may be used. For example, the first inserts 218a, the second inserts 218b, and/or the third inserts 218c may be grouped by like material (i.e., located adjacent to the inserts 218a-218c with like deposition material). In the illustrated cathode 200d, the inserts 218 are similarly sized and shaped, and more inserts 218a and 218b are included than inserts 218c. As a result, the deposited coating includes more of the second and third deposition materials than the fourth deposition material. The number of each type of the inserts 218a-218c may vary, along with the relative dimensions thereof, depending on the desired amount of the respective deposition material included in the deposited coating. The second, third, and/or fourth deposition material may be incompatible with the first deposition material of the main body 202. Additionally and/or alternatively, the second deposition material may be incompatible with the third and/or fourth deposition material, and/or the third and fourth deposition materials may be incompatible.

FIG. 8 is a fifth exemplary alternative embodiment of the cathode 200, indicated generally at 200e. In this embodiment, the cathode 200e includes the main body 202 fabricated from a first deposition material, two insulating inserts 224 (labeled 224a and 224b), and an insert 218 fabricated from a second deposition material. As described above, the first and second deposition materials may be incompatible with one another. Each of the insulating inserts 224a and 224b is fabricated from an electrically insulating material that does not support a cathodic arc, such as, for example, alumina or boron nitride. The insulating inserts 224a and 224b control movement of the cathodic arc at the working cathode surface 204. A first insulating insert 224a is cylindrically-shaped and positioned in a center region of the working cathode surface 204. A second insulating insert 224b is annularly-shaped and positioned between the peripheral edge 210 of the main body 202 and the remaining portion of the working cathode surface 204 located radially between the insulating inserts 224a and 224b. In some embodiments, the annularly-shaped insulating insert 224b may surround the main body 202 of the cathode 200e, including the circumferential edge 208 (shown in FIGS. 2 and 3). The region of the working cathode surface 204 between the insulating inserts 224a and 224b may be substantially flat. The insulating inserts 224a and 224b may cooperate to control movement of the cathodic arc to concentrate along a circumferential path (indicated by arrows 228 in FIG. 8) located radially between the insulating inserts. Suitably, the insert 218 fabricated from the second deposition material located between the insulating inserts 224a and 224b and along the region of the working cathode surface 204 where concentration of the cathodic arc is controlled. In the exemplary cathode 200e, the insert 218 is annularly-shaped. In other embodiments, more or fewer inserts 218 may be included. For example, multiple annularly-shaped inserts 218 may be included, and may include the same or different deposition material. Additionally and/or alternatively, the inserts 218 of the cathode 200e may have any suitable size and/or shape. For example, the inserts 218 may be shaped as illustrated in any of FIGS. 2-7 and described above. The number, size, and/or shape of the inserts 218 may vary depending on a desired composition of the deposited coating as described above.

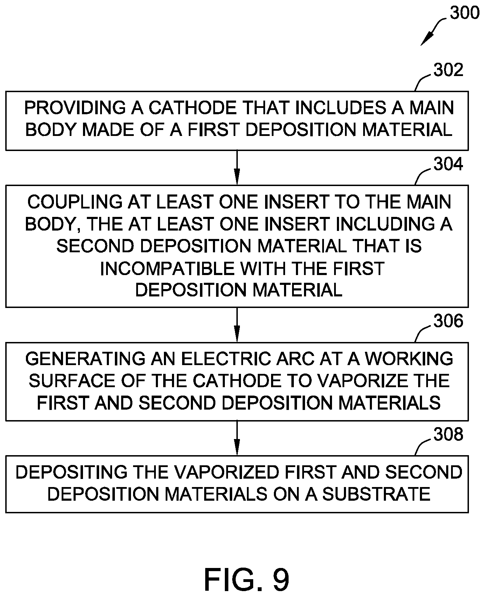

FIG. 9 illustrates an exemplary method 300 of depositing a coating material on a substrate, such as the workpiece 108 described above with reference to FIG. 1. The method 300 may be performed using the IPD apparatus 100 (shown in FIG. 1). The method includes providing 302 a cathode (e.g., the cathode 200) that includes a main body (e.g., the main body 202) defining a working cathode surface (e.g., the working cathode surface 204). The main body includes a first deposition material that is vaporizable in response to a cathode (or electric) arc generated at the working cathode surface. The method 300 also includes coupling 304 at least one insert (e.g., at least one insert 218) to the main body. The at least one insert may be coupled 304 to the main body by forming a corresponding opening (e.g., an opening 216) in the working cathode surface for each insert and positioning each insert in the corresponding opening. Each insert may be retained in the corresponding opening via a friction (or press) fit. The at least one insert includes a second deposition material that is vaporizable in response to a cathode (or electric) arc generated at the working cathode surface. The second deposition material is different from, and may be incompatible with, the first deposition material. When the at least one insert is coupled 304 to the main body, the at least one insert is at least partially exposed (e.g., has an exposed surface 220) at the working cathode surface.

The method 300 also includes generating 306 an electric (or cathodic) arc at the working cathode surface to thereby vaporize the first and second deposition materials. To generate 306 the cathodic arc, the cathode and the substrate may be positioned in a vacuum environment (e.g., within the vacuum chamber 102) and a current is supplied to the cathode (e.g., via the DC power supply 114) to create a sufficient potential between the cathode and the substrate. The substrate may also be provided with a ground potential or a negative voltage bias, as described above. The cathodic arc generated 306 at the working cathode surface erodes or vaporizes the first deposition material of the main body and the second deposition material of the at least one insert from the working cathode surface. The erosion or vaporization of the first and second deposition materials forms a cloud of droplets and ions of coating material which is deposited 308 on a surface of the substrate by condensation and/or electrical attraction. The deposited coating includes the first and second deposition materials, which may be incompatible and therefore remain separated until the materials are vaporized to facilitate mitigating or preventing the cathode from prematurely breaking apart before or during the deposition process. In some embodiments, the method 300 may include controlling movement of the cathodic arc generated 306 at the working cathode surface. For example, the method 300 may include coupling an insulating insert (e.g., an insulating insert 224) to the main body such that the insulating insert is at least partially exposed (e.g., has an exposed surface 226) at the working cathode surface, and controlling movement of the electric arc at the working cathode surface using the insulating insert. Additionally and/or alternatively, the method 300 may include forming a dished or sunk shape of the working cathode surface, and controlling movement of the electric arc at the working cathode surface using the shape of the working cathode surface.

The above systems and methods facilitate overcoming at least some of the limitations and costs associated with current IPD processes by using "hybrid" cathodes that include a main body fabricated from a first deposition material and at least one insert coupled to the main body that is fabricated from a second, different deposition material. The hybrid cathode enables the first and second deposition materials to be deposited on a substrate. In particular, the exemplary hybrid cathodes enable incompatible materials to be concurrently deposited on the substrate from a single cathode, while facilitating reducing or eliminating the propensity of the cathode to prematurely break apart or fail before or during deposition. The second deposition material may be incompatible with the first deposition material, as the incompatible deposition materials remain separated until they are vaporized and deposited on the substrate.

Inserts coupled to the main body may also be readily removed from the main body and be selectively replaced with inserts fabricated from yet other materials for deposition, which may advantageously enable the use of a wide variety materials in a single cathode. The exemplary hybrid cathodes may also be configured (e.g., by shaping the working cathode surface and/or including one or more insulating inserts) in such a way that the cathodic arc can be controlled as it circumnavigates the working cathode surface. The exemplary hybrid cathodes thus overcome at least some of the current limitations of IPD processes, including facilitating reducing costs and overcoming the inability to produce compositionally-complex coatings. Additionally, the exemplary hybrid cathodes facilitate the use of additional coating materials to be available to the coating process and thus significantly reduce costs associated with the IPD process by allowing the process to be operated for longer periods of time without having to replace the cathodes. Moreover, by not requiring the cathode to be replaced as often, a more uniform and improved coating material may be deposited.

### EXAMPLE

The following non-limiting Example further illustrates the subject matter of the present disclosure.

Preparation of monolithic cathodes for use in depositing an Nb-Si-Ti-Al-Hf alloy coating including various atomic percentages of niobium (Nb), silicon (Si), titanium (Ti), aluminum (Al), and hafnium (Hf) was attempted by mixing the elements in their respective amounts and casting the cathodes. The solid material was too brittle and cracked into multiple pieces during casting. The solid material also could not withstand mechanical stresses during machining and could not be machined to a suitable size and shape without cracking and breaking apart.

Accordingly, a hybrid cathode capable of depositing the desired chemistry of the Nb-Si-Ti-Al-Hf alloy coating was prepared by casting a main body of the cathode from a Ti-Al-Si alloy including between about 18 to about 22 at % Si, between about 18 to about 22 at % Ti, and between about 58 to about 62 at % Al, which provided suitable solid strength and ductility for casting and machining the main cathode body. Inserts fabricated from 100 at % of p-doped Si and Nb-Si-Ti-Hf alloy containing from between about 35 to about 38 at % Nb, between about 11 to about 15 at % Si, between about 33 to about 37 at % Ti, and between about 14 to about 17 at % Hf, were obtained and also had suitable strength and ductility to prevent against failure of the inserts. The Si and Nb-Si-Ti-Hf alloy inserts were forcibly inserted into openings machined in a working surface of the main Ti-Al-Si alloy cathode body and the inserts were partially exposed at the working surface. An insulating insert fabricated from boron nitride (BN) was also obtained and forcibly inserted in a corresponding opening formed in a radially center region of the working surface of the Ti-Al-Si alloy cathode body. The Si and Nb-Si-Ti-Hf alloy inserts were positioned circumferentially around the insulating BN insert to enable the cathodic arc to shift towards the Si and Nb-Si-Ti-Hf alloy inserts while avoiding the BN insert at the working surface during operation of the hybrid cathode. The hybrid cathode was thereby manufactured to include the requisite chemistries for depositing the desired Nb-Si-Ti-Al-Hf alloy coating in the single hybrid cathode while reducing the propensity for cathode failure.

Further aspects of the present disclosure are provided by the subject matter of the following clauses:
Clause 1. A cathode for use in an ion deposition process, said cathode comprising: a main body defining a working surface of the cathode, the main body including a first deposition material; and at least one insert coupled to the main body, wherein the at least one insert is at least partially exposed at the working cathode surface, and wherein the at least one insert includes a second deposition material that is incompatible with the first deposition material; wherein the first and second deposition materials are vaporizable in response to an electric arc generated at the working cathode surface for depositing a coating including the first and second deposition materials on a substrate.
Clause 2. The cathode of Clause 1, wherein the at least one insert comprises at least two inserts coupled to the main body, wherein each insert is at least partially exposed at the working cathode surface.
Clause 3. The cathode of Clause 2, wherein the at least two inserts are arranged such that exposed portions of the inserts are spaced circumferentially at the working cathode surface.
Clause 4. The cathode of Clause 2 or Clause 3, wherein the at least two inserts comprise a first insert including the second deposition material and a second insert including a third deposition material that is different from the second deposition material and that is incompatible with the first deposition material.
Clause 5. The cathode of Clause 2 or Clause 3, wherein the at least two inserts comprise a first insert including the second deposition material and a second insert including a third deposition material that is incompatible with one of the first and second deposition materials.
Clause 6. The cathode of any one of Clauses 2 to 5, wherein the at least two inserts comprise an insulating insert that includes an insulating material configured to facilitate controlling movement of the electric arc generated at the working cathode surface.
Clause 7. The cathode of Clause 6, wherein the insulating material comprises one of alumina and boron nitride.
Clause 8. The cathode of any one of the preceding clauses, wherein the first deposition material comprises at least one element selected from the group consisting of nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, and boron.
Clause 9. The cathode of any one of the preceding clauses, wherein the second deposition material comprises at least one element selected from the group consisting of nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, and boron.
Clause 10. The cathode of any one of the preceding clauses, wherein each insert is retained in a corresponding opening formed in the main body of the cathode.
Clause 11. The cathode of Clause 10, wherein each insert is retained in the corresponding opening via at least one of a friction fit and a threaded engagement.
Clause 12. An apparatus for depositing a coating on a substrate, said apparatus comprising: a deposition chamber sized to receive the substrate therein; a cathode positioned in the deposition chamber, the cathode comprising: a main body defining a working surface of the cathode, the main body including a first deposition material; at least one deposition insert coupled to the main body, wherein the at least one deposition insert is at least partially exposed at the working cathode surface, and wherein the at least one deposition insert includes a second deposition material that is incompatible with the first deposition material; and a power supply coupled to the cathode, wherein the power supply is operable to generate an electric arc at the working cathode surface for vaporizing the first and second deposition materials and depositing the coating including the first and second deposition materials on the substrate.
Clause 13. The apparatus of Clause 12, wherein the cathode further comprises an insulating insert coupled to the main body and at least partially exposed at the working cathode surface, wherein an exposed portion of the insulating insert is positioned to facilitate controlling movement of the electric arc at the working cathode surface.
Clause 14. The apparatus of Clause 13, wherein the exposed portion of the insulating insert is positioned in a center region of the working cathode surface to facilitate controlling circumferential movement of the electric arc at the working cathode surface.
Clause 15. The apparatus of Clause 14, wherein the at least one deposition insert comprises at least two deposition inserts coupled to the main body, wherein each deposition insert is at least partially exposed at the working cathode surface at a location radially outward from the exposed portion of the insulating insert.
Clause 16. The apparatus of Clause 15, wherein the at least two deposition inserts comprise a first deposition insert including the second deposition material and a second deposition insert including a third deposition material different from the second deposition material.
Clause 17. The apparatus of Clause 16, wherein the third deposition material is incompatible with at least one of the first and second deposition materials.
Clause 18. A method of depositing a coating on a substrate, said method comprising: providing a cathode including a main body defining a working surface of the cathode, wherein the main body includes a first deposition material; coupling at least one insert to the main body, wherein the at least one insert including a second deposition material that is incompatible with the first deposition material, such that the at least one insert is at least partially exposed at the working cathode surface; generating an electric arc at the working cathode surface to thereby vaporize the first and second deposition materials; and depositing the vaporized first and second deposition materials on a substrate.
Clause 19. The method of Clause 18, wherein coupling the at least one insert to the main body comprises: forming a corresponding opening in the working cathode surface for each insert; and positioning each insert in the corresponding opening such that each insert is retained in the corresponding opening via at least one of a friction fit and a threaded engagement.
Clause 20. The method of Clause 18, further comprising: coupling an insulating insert to the main body such that the insulating insert is at least partially exposed at the working cathode surface; and controlling movement of the electric arc at the working cathode surface using the insulating insert.

Exemplary embodiments of ion plasma deposition systems and methods for depositing a coating material on a substrate using a hybrid cathode are described above in detail. The methods and systems are not limited to the specific embodiments described herein, but rather, components of systems and/or steps of the methods may be utilized independently and separately from other components and/or steps described herein. For example, the systems and methods may also be used in combination with many types of components, and are not limited to practice only with components of rotary machines (e.g., a gas turbine engine) as described herein. Rather, the exemplary embodiment can be implemented and utilized in connection with many other ion plasma deposition applications or applications that involve depositing a coating material from incompatible materials.

Although specific features of various embodiments of the present disclosure may be shown in some drawings and not in others, this is for convenience only. References to "one embodiment" in the above description do not exclude the existence of additional embodiments that also incorporate the recited features. In accordance with the principles of embodiments of the present disclosure, any feature of a drawing may be referenced and/or claimed in combination with any feature of any other drawing.

This written description uses examples to disclose the embodiments of the present disclosure, including the best mode, and also to enable any person skilled in the art to practice embodiments of the present disclosure, including making and using any devices or systems and performing any incorporated methods. The patentable scope of the embodiments described herein is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A cathode (200) for use in an ion deposition process, said cathode comprising:
a main body (202) defining a working surface (204) of the cathode, the main body including a first deposition material; and
at least one insert (218) coupled to the main body, wherein the at least one insert is at least partially exposed at the working cathode surface, and wherein the at least one insert includes a second deposition material that is incompatible with the first deposition material;
wherein the first and second deposition materials are vaporizable in response to an electric arc generated at the working cathode surface for depositing a coating including the first and second deposition materials on a substrate (108).

2. The cathode (200) of Claim 1, wherein the at least one insert (218) comprises at least two inserts coupled to the main body (202), wherein each insert is at least partially exposed at the working cathode surface (204).

3. The cathode (200) of Claim 2, wherein:
the at least two inserts are arranged such that exposed portions (220) of the inserts (218) are spaced circumferentially at the working cathode surface (204); and/or
the at least two inserts comprise a first insert including the second deposition material and a second insert including a third deposition material, optionally wherein the third deposition material different from the second deposition material and/or incompatible with one of the first and second deposition materials; and/or
the at least two inserts comprise an insulating insert (224) that includes an insulating material configured to facilitate controlling movement of the electric arc generated at the working cathode surface, optionally wherein the insulating material comprises one of alumina and boron nitride.

4. The cathode (200) of any one of Claims 1 to 3, wherein the first deposition material comprises at least one element selected from the group consisting of nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, and boron.

5. The cathode (200) of any one of Claims 1 to 4, wherein the second deposition material comprises at least one element selected from the group consisting of nickel, aluminum, cobalt, chromium, molybdenum, tungsten, rhenium, ruthenium, zirconium, hafnium, tantalum, silicon, yttrium, titanium, lanthanum, cerium, niobium, vanadium, platinum, iridium, osmium, palladium, rhodium, carbon, and boron.

6. The cathode (200) of any one of Claims 1 to 5, wherein each insert (218) is retained in a corresponding opening (216) formed in the main body (202) of the cathode, optionally wherein each insert is retained in the corresponding opening via at least one of a friction fit and a threaded engagement.

7. An apparatus (100) for depositing a coating on a substrate (108), said apparatus comprising:
a deposition chamber (102) sized to receive the substrate therein;
a cathode (200) positioned in the deposition chamber, the cathode comprising:
a main body (202) defining a working surface (204) of the cathode, the main body including a first deposition material;
at least one deposition insert (218) coupled to the main body, wherein the at least one deposition insert is at least partially exposed at the working cathode surface, and wherein the at least one deposition insert includes a second deposition material that is incompatible with the first deposition material; and
a power supply (114) coupled to the cathode, wherein the power supply is operable to generate an electric arc at the working cathode surface for vaporizing the first and second deposition materials and depositing the coating including the first and second deposition materials on the substrate.

8. The apparatus (100) of Claim 7, wherein the cathode further comprises an insulating insert (224) coupled to the main body (202) and at least partially exposed at the working cathode surface (204), wherein an exposed portion (226) of the insulating insert is positioned to facilitate controlling movement of the electric arc at the working cathode surface.

9. The apparatus (100) of Claim 8, wherein the exposed portion (220) of the insulating insert (218) is positioned in a center region of the working cathode surface (204) to facilitate controlling circumferential movement of the electric arc at the working cathode surface.

10. The apparatus (100) of Claim 9, wherein the at least one deposition insert (218) comprises at least two deposition inserts coupled to the main body (202), wherein each deposition insert is at least partially exposed at the working cathode surface (204) at a location radially outward from the exposed portion (226) of the insulating insert (224).

11. The apparatus (100) of Claim 10, wherein the at least two deposition inserts (218) comprise a first deposition insert including the second deposition material and a second deposition insert including a third deposition material different from the second deposition material.

12. The apparatus (100) of Claim 11, wherein the third deposition material is incompatible with at least one of the first and second deposition materials.

13. A method (300) of depositing a coating on a substrate, said method comprising:
providing (302) a cathode including a main body defining a working surface of the cathode, wherein the main body includes a first deposition material;
coupling (304) at least one insert to the main body, wherein the at least one insert including a second deposition material that is incompatible with the first deposition material, such that the at least one insert is at least partially exposed at the working cathode surface;
generating (306) an electric arc at the working cathode surface to thereby vaporize the first and second deposition materials; and
depositing (308) the vaporized first and second deposition materials on a substrate.

14. The method (300) of Claim 13, wherein coupling (304) the at least one insert to the main body comprises:
forming a corresponding opening in the working cathode surface for each insert; and
positioning each insert in the corresponding opening such that each insert is retained in the corresponding opening via at least one of a friction fit and a threaded engagement.

15. The method (300) of Claim 13, further comprising:
coupling an insulating insert to the main body such that the insulating insert is at least partially exposed at the working cathode surface; and
controlling movement of the electric arc at the working cathode surface using the insulating insert.
